# EUROPEAN PATENT APPLICATION

(11) **EP 2 891 731 A1**
(43) Date of publication of application: **08.07.2015**
(21) Application number: 13833290.3
(22) Date of filing: 29.08.2013
(51) Int. Cl.: C30B 29/30, C30B 11/00

(54) **SOLID ELECTROLYTE SINGLE CRYSTAL HAVING PEROVSKITE STRUCTURE AND METHOD FOR PRODUCING SAME**

(30) Priority: 29.08.2012 JP 2012188263; 31.10.2012 JP 2012240995
(71) Applicant: Toyota Jidosha Kabushiki Kaisha, Toyota-shi, Aichi 471-8571 (JP); Shinshu University, Matsumoto-shi, Nagano 390-8621 (JP)
(72) Inventor: FUJIWARA, Yasuyuki, Toyota-shi Aichi 471-8571 (JP); HOSHIKAWA, Keigo, Nagano-shi Nagano 380-8553 (JP)
(74) Representative: TBK
(86) International application number: PCT/JP2013/073184
(87) International publication number: WO 2014/034794

(57) **Abstract**

Provided is a solid electrolyte single crystal having a perovskite structure and a producing method thereof. Provided is a method for producing a solid electrolyte single crystal having a perovskite structure including: a heating step of heating a raw material for producing a single crystal of a solid electrolyte having a perovskite structure to a temperature of a melting point of the solid electrolyte or more to obtain a molten body; and a cooling step of cooling the obtained molten body to a temperature of a solidifying point of the solid electrolyte or less, and the solid electrolyte single crystal having a perovskite structure produced by the method.

## Description

### BACKGROUND OF THE INVENTION

### Field of the Invention

The present invention relates to a solid electrolyte single crystal having a perovskite structure and a method for producing the solid electrolyte single crystal having a perovskite structure.

### Description of the Related Art

A lithium-ion secondary battery has a higher energy density and is operable at a high voltage compared to conventional secondary batteries. Therefore, it is used for information devices such as a cellular phone, as a secondary battery which can be easily reduced in size and weight, and nowadays there is also an increasing demand for the lithium-ion secondary battery to be used as a power source for large-scale apparatuses such as electric vehicles and hybrid vehicles.

The lithium-ion secondary battery includes a cathode layer, an anode layer, and an electrolyte layer arranged between them. An electrolyte to be employed in the electrolyte layer is, for example, a non-aqueous liquid or a solid. When the liquid is used as the electrolyte (hereinafter, the liquid being referred to as "electrolytic solution"), it easily permeates into the cathode layer and the anode layer. Therefore, an interface can be formed easily between the electrolytic solution and active materials contained in the cathode layer and the anode layer, and the battery performance can be easily improved. However, since commonly used electrolytic solutions are flammable, it is necessary to have a system to ensure safety. On the other hand, if a nonflammable solid electrolyte (hereinafter referred to as "solid electrolyte") is used, the above system can be simplified. As such, a lithium-ion secondary battery provided with a layer containing a solid electrolyte has been suggested (hereinafter, the layer being referred to as "solid electrolyte layer" and the battery being referred to as "solid-state battery").

For the solid electrolyte layer of the solid-state battery, a solid electrolyte obtained by compacting or sintering a powder obtained by means of a solid phase synthesize and the like is generally used. However, each powder of the solid electrolyte in this state is polycrystalline. Therefore, a grain boundary exists between the powder and inside the powder of the solid electrolyte, which is one of the causes of deterioration in lithium ion conductivity. Even if the solid electrolyte is formed in a sintered body, it is difficult to make its density as 100%, and a gap and a hole existing inside the sintered body cause the deterioration in lithium ion conductivity.

For example, LiₓLa_{(1-x)/3}NbO₃, which is a solid electrolyte whose crystal structure is a perovskite structure (hereinafter the solid electrolyte may be referred to as "perovskite-type solid electrolyte" or "solid electrolyte having a perovskite structure") and whose synthetic powder can be obtained by means of a solid phase synthesis or a flux method, is in many cases molded having a high density as much as possible by sintering, to be used for a solid-state battery. Since the sintered body has the above character, it is considered that using a single crystal of LiₓLa_{(1-x)/3}NbO₃ is effective to improve the lithium ion conductivity of the solid-state battery prepared with LiₓLa_{(1-x)/3}NbO₃. However, there is no report that a single crystal of LiₓLa_{(1-x)/3}NbO₃ has been produced, and no state diagram which is to be a guiding principle in producing a single crystal of LiₓLa_{(1-x)/3}NbO₃ has been produced at the moment.

As a technique related to a material which can be used for the solid-state battery, for example Patent Literature 1 discloses a lithium ion conductor consisting of a composite oxide having a perovskite structure, wherein half or more of the A site of the perovskite structure is occupied by lithium and trivalent metal atom. In Patent Literature 1, LiₓLa_{y}TiO₃ and the like are exemplified as the lithium ion conductor. Patent Literature 2 discloses a method for producing lithium niobate single crystal by means of a horizontal Bridgman method. Patent Literature 3 discloses a method for producing a single crystal material having a high melting point, the method including, when a single crystal material consisting of metal or metallic compound and having a high melting point of 1700°C or more is made, using a Bridgman method of moving a crucible in which a single crystal seed is contained, in a furnace having a temperature gradient to thereby raise a single crystal. Also, Patent Literature 4 discloses a method for producing a crystal including steps of arranging a seed crystal in a crucible held in a furnace, heating to liquefy a raw material filled in the crucible, and gradually cooling the raw material in a liquid form from a lower portion to an upper portion of the crucible, the method being provided with: a first step of calculating in advance the growth amount and the growth speed of the growing crystal, based on the liquidus of phase diagram configured by a constituent element of the raw material in a liquid form and the temperature distribution inside the furnace; and a second step of controlling a cooling speed of the crucible so that the crystal has the growth speed calculated in the first step.

### Citation List

### Patent Literatures

Patent Literature 1: Japanese Patent Application Laid-Open No. H07-169456
Patent Literature 2: Japanese Patent Application Laid-Open No. H04-65399
Patent Literature 3: Japanese Patent Application Laid-Open No. 2007-119297
Patent Literature 4: Japanese Patent Application Laid-Open No. 2007-99581

### SUMMARY OF INVENTION

### Problems to be Solved by Invention

Patent Literature 1 does not disclose a technical idea of using a single crystal of a perovskite-type solid electrolyte. Patent Literatures 2 to 4 disclose techniques which can be used in producing a single crystal by means of a horizontal Bridgman method. However, as mentioned above, since LiₓLa_{(1-x)/3}NbO₃ does not have a state diagram, its melting point and solidifying point are unknown. Therefore, even though Patent Literatures 2 to 4 are combined, it is difficult to obtain a single crystal of a perovskite-type solid electrolyte represented by LiₓLa_{(1-x)/3}NbO₃ (0<x≤0.23) or the like. It should be noted that, since the method disclosed in Patent Literature 3 uses a single crystal seed, it can be considered that regarding the perovskite-type solid electrolyte whose single crystal has not been obtained, it is difficult to produce a perovskite-type solid electrolyte single crystal, even by means of the method disclosed in Patent Literature 3.

Accordingly, an object of the present invention is to provide a solid electrolyte single crystal having a perovskite structure and a producing method thereof.

### Means for Solving Problems

As a result of an intensive study, the inventors of the present invention have found out that it is possible to produce a single crystal of a perovskite-type solid electrolyte by: using a polycrystal body of a perovskite-type solid electrolyte, a raw material powder used in producing the polycrystal body of the perovskite-type solid electrolyte, or a sintering material of the raw material powder as a raw material in producing the single crystal; and going through a process of heating the raw material in producing the single crystal to a predetermined temperature to dissolve it, thereafter cooling the obtained material along a predetermined temperature gradient.

The inventors have also found out that: by heating to dissolve the raw material in a short time from a room temperature or in a temperature range in which the raw material does not change its state; thereafter starting cooling in the predetermined time period to solidify the single crystal, it is possible to reduce different phase possibly formed at a solidification starting end of the single crystal produced by going through the above process. Further, the inventors have found out that it is possible to make the different phase unevenly exist, by inclining a solid/liquid interface formed when the single crystal is developed (cooled), to a surface having a growing direction of the single crystal as a normal direction. In addition, the inventors have found out that it is possible to prevent internal defects (such as cracks) inside the single crystal by, in returning the temperature of the produced single crystal to a normal temperature, making the cooling speed in a predetermined temperature range have a predetermined value or less, or making the temperature difference between the solidification starting end and a solidification finishing end of the single crystal have a predetermined value or less.

The present invention has been made based on the above findings.

In order to solve the above problems, the present invention takes the following means. Namely, a first aspect of the present invention is a solid electrolyte single crystal having a perovskite structure.

In the first aspect of the present invention, a composition formula of the solid electrolyte single crystal having a perovskite structure may be LiₓLa_{(1-x)/3}NbO₃. This configuration makes it easy to obtain the solid electrolyte single crystal having a perovskite structure.

Also, in the first aspect of the present invention in which the composition formula is LiₓLa_{(1-x)/3}NbO₃, it is preferable that 0<x≤0.23. This configuration makes it easy to obtain the solid electrolyte single crystal of a single phase of a perovskite structure.

A second aspect of the present invention is a method for producing a solid electrolyte single crystal having a perovskite structure, the method including: a heating step of heating a raw material for producing a single crystal of a solid electrolyte having a perovskite structure to a temperature of a melting point of the solid electrolyte or more to obtain a molten body; and a cooling step of cooling the molten body to a temperature of a solidifying point of the solid electrolyte or less. This configuration makes it possible to produce the single crystal of the solid electrolyte having a perovskite structure and to produce a bulk single crystal.

Also, in the second aspect of the present invention, the cooling step may be a step of cooling the molten body in one direction. Such a configuration also makes it possible to produce the solid electrolyte single crystal having a perovskite structure.

Also, in the second aspect of the present invention, the single crystal may be grown by means of a Bridgman method. Here, the term "Bridgman method" includes a so-called vertical Bridgman method and horizontal Bridgman method. Such a configuration also makes it possible to produce the solid electrolyte single crystal having a perovskite structure.

Also, in the second aspect of the present invention, a composition formula of the solid electrolyte may be LiₓLa_{(1-x)/3}NbO₃. Such a configuration makes it possible to produce a single crystal of LiₓLa_{(1-x)/3}NbO₃ which is a perovskite-type solid electrolyte.

In the second aspect of the present invention in which the composition formula of the solid electrolyte is LiₓLa_{(1-x)/3}NbO₃, it is preferable that 0<x≤0.23. Such a configuration makes it easy to produce a single crystal of LiₓLa_{(1-x)/3}NbO₃ of single phase of a perovskite structure.

In the second aspect of the present invention in which the composition formula of the solid electrolyte is LiₓLa_{(1-x)/3}NbO₃, the melting point may be 1291°C or more and less than 1386°C. By determining the heating temperature in the heating step along such a temperature, it becomes easy to melt the raw material.

Also, in the second aspect of the present invention in which the composition formula of the solid electrolyte is LiₓLa_{(1-x)/3}NbO₃, the solidification point may be 1291°C or more and less than 1386°C. By determining the cooling temperature in the cooling step along such a temperature, it becomes easy to produce the single crystal of LiₓLa_{(1-x)/3}NbO₃. It should be noted that the melting point and the solidification point of LiₓLa_{(i-x)/3}NbO₃ (0<x≤0.23) is 1291°C when x=0.23; however when 0<x<0.23, the melting point becomes higher than the solidification point.

Also, in the second aspect of the present invention, in the heating step, it is preferable that a molten body is obtained within 0.25 hours after the heating of the raw material is started, and the cooling step is started within 0.25 hours after the molten body is obtained. This configuration makes it possible to reduce the different phase formed to the solidification starting end of the single crystal. As a result, in addition to the above effect, it becomes possible to increase the yield of the single crystal (the ratio of single crystal region to the whole sample) and to reduce the different phase which possibly precipitates in the single crystal.

In the second aspect of the present invention, it is preferable to cool the molten body in the cooling step to a temperature of the solidifying point of the solid electrolyte or less, while inclining a solid/liquid interface formed in the cooling step, to a surface having a growing direction of the single crystal as a normal direction. Such a configuration easily makes the different phase which can be formed together with the single crystal unevenly precipitated. Therefore, in addition to the above effect, it becomes easy to produce the single crystal not including any small precipitated different phase.

In the second aspect of the present invention, after the cooling step, it is preferable to include a single crystal cooling step of cooling the obtained single crystal, and preferably the single crystal cooling step includes a step of cooling the single crystal while making a temperature difference between a solidification starting end of the single crystal and a solidification finishing end of the single crystal as 25°C or less. In addition to the above effect, such a configuration makes it easy to produce the single crystal not having internal defects such as cracks.

In the second aspect of the present invention which has the single crystal cooling step having a step of cooling the single crystal while making the temperature difference between the solidification starting end and the solidification finishing end of the single crystal as 25°C or less, in the step of cooling the single crystal while making the temperature difference between the solidification starting end and the solidification finishing end of the single crystal as 25°C or less, it is preferable that a cooling speed of the single crystal in a process in which the temperature of the single crystal reaches from 900°C to 150°C is made to be less than 0.27 °C/min. Such a configuration makes it further easy to produce the single crystal not having internal defects such as cracks.

### Effects of Invention

According to the present invention, it is possible to provide a solid electrolyte single crystal having a perovskite structure and a producing method thereof.

### BRIEF DESCRIPTION OF DRAWINGS

Fig. 1 is a view of a LiₓLa_{(1-x)/3}NbO₃ sintered body;
Fig. 2 is a graph showing a result of an X-ray diffraction measurement of the LiₓLa_{(1-x)/3}NbO₃ sintered body:
Fig. 3 is a view to explain a melting/solidifying experiment;
Fig. 4A is a view showing a relationship between the temperature and time of Li_{0.175}La_{0.275}NbO₃ when the temperature is increased;
Fig. 4B is a view showing a relationship between the temperature and time of Li_{0.175}La_{0.275}NbO₃ when the temperature is decreased;
Fig. 5 is a graph showing a result of an X-ray diffraction measurement of a solidified Li_{0.175}La_{0.275}NbO₃;
Fig. 6A is a graph showing a relationship between the melting point and solidifying point of LiₓLa_{(1-x)/3}NbO₃ and x; in the heating step in the method for producing a solid electrolyte single crystal having a perovskite structure of the present invention, the single crystal is for example heated to a temperature identified by the upwardly convexed line shown in this figure or more, and in the cooling step, the single crystal is for example cooled to the temperature identified by the downwardly convexed line shown in this figure or less;
Fig. 6B is a flowchart to explain one configuration of the method for producing a solid electrolyte single crystal having a perovskite structure of the present invention;
Fig. 6C is a view to explain one example of a configuration in which a molten body is cooled in one direction;
Fig. 6D is a view to explain one configuration of the heating step and the cooling step;
Fig. 6E is a flowchart to explain one configuration of the method for producing a solid electrolyte single crystal having a perovskite structure of the present invention;
Fig. 6F is a view to explain the temperature difference between a solidification starting end of the single crystal and a solidification finishing end of the single crystal;
Fig. 6G is a view to explain a horizontal Bridgman method;
Fig. 7 is a view showing a solidified body including Li_{0.1}La_{0.3}NbO₃ single crystal;
Fig. 8 includes a graph showing a result of an X-ray diffraction measurement of the solidified body including Li_{0,1}La_{0,3}NbO₃ single crystal;
Fig. 9 is a view showing results of a peak measurement wherein x=0.1;
Fig. 10 is a view showing results of a peak measurement wherein X=0.075;
Fig. 11 is a view showing results of a peak measurement wherein x=0.22;
Fig. 12 is a graph to explain a relationship between the ion conductivity and x;
Fig. 13 is a view showing an appearance of a single crystal;
Fig. 13B is a view showing a cross section of the single crystal;
Fig. 14A is a view showing an appearance of a sample in which the different phase of a solidification starting end side of the single crystal is reduced;
Fig. 14B is a view showing an appearance of a sample in which the different phase on the solidification starting end side of the single crystal is not reduced;
Fig. 15A is an enlarged view of the sample of the single crystal on the solidification starting end side in which the different phase on the solidification starting end is reduced;
Fig. 15B is an enlarged view of the sample of the single crystal on the solidification starting end side in which the different phase on the solidification starting end is not reduced;
Fig. 16A is a view showing a cross section in a single crystal region of the sample in which the different phase on the solidification starting end side of the single crystal is reduced;
Fig. 16B is a view showing a cross section in a single crystal region of the sample in which the different phase on the solidification starting end side of the single crystal is not reduced;
Fig. 17 is a view to explain states of the crystal, the solid/liquid interface, and the molten liquid in a crucible where a vertical Bridgman method is employed;
Fig. 18 is a view to explain states of the crystal, the solid/liquid interface, and the molten liquid in the crucible in a case where the solid/liquid interface is inclined;
Fig. 19A is a view showing an appearance of a single crystal in which the different phase unevenly exists;
Fig. 19B is a view showing an appearance of the single crystal in which the different phase unevenly exists;
Fig. 20A is a view showing a cross section of a single crystal in which the different phase does not unevenly exist;
Fig. 20B is a view showing a cross section of the single crystal in which the different phase unevenly exists;
Fig. 21 is a graph to explain a relationship (cooling speed of the single crystal) between the temperature and the time when the produced single crystal is cooled in the single crystal cooling step; and
Fig. 22 is a view to explain a perovskite structure.

### Means for Solving the Problems

Hereinafter the present invention will be described. In the following explanation, a method for producing a single crystal of LixLa_{(i-x)/3}NbO₃, and a single crystal of LiₓLa_{(1-x)/3}NbO₃ obtained by the method will be exemplified. However, the present invention is not limited to this configuration. In a case where a single crystal of a solid electrolyte having a perovskite structure other than LixLa_{(1-x)/3}NbO₃ is produced, the melting point and the solidifying point of the single phase of the solid electrolyte whose single crystal is intended to be produced are specified for example by carrying out a melting/solidifying experiment mentioned below. Then, by obtaining a molten body by heating the raw material at a temperature of the specified melting point or more, thereafter going through a process of cooling the molten body, it becomes possible to produce a single crystal of a solid electrolyte having a perovskite structure.

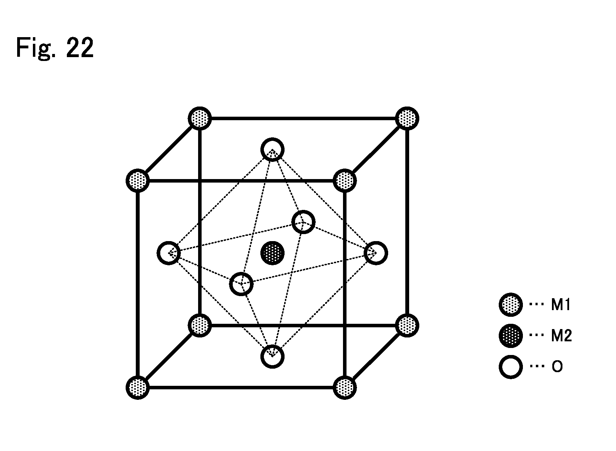

Fig. 22 is a view to explain a perovskite structure. As shown in Fig. 22, the perovskite structure includes a first metal M1 at each apex of its cubic crystal, a second metal M2 at the body center, and oxygen O at each face center of the cubic crystal.

In producing a single crystal of LixLa_{(1-x)/3}NbO₃ (hereinafter sometimes referred to as "LLNbO") which is a perovskite-type solid electrolyte, single phase LLNbO synthesized by means of the following method, and LiNbO₃, LaNb₃O₉ and the like that are the raw materials in producing LLNbO can be used as a raw material.

In a case where the single phase LLNbO is used as the raw material, the single phase LLNbO can be obtained by the following two methods for example.

In the first method, a calcined powder is obtained by: obtaining a mixture powder by mixing Li₂CO₃, La₂O₃, and Nb₂O₅ each having a diameter of less than 5 µm; thereafter calcinating the obtained mixture powder at a temperature of 700°C or more and 850°C or less. Next, the obtained calcined powder is grinded, thereafter heated at a temperature of 1190°C or more and 1250°C or less, whereby it is possible to produce the single phase LLNbO (sintered body). Whether the single phase LLNbO is produced or not can be judged by whether a peak of a substance other than LLNbO is confirmed or not by an X-ray diffraction measurement. In a case where it is judged that the obtained sintered body is not single phase LLNbO from the peak of a substance other than LLNbO confirmed by an X-ray diffraction measurement, the single phase LLNbO can be obtained by grinding the obtained sintered body and repeating the grinding and firing (firing at a temperature of 1190°C or more and 1250°C or less) until the peak originated from a substance other than LLNbO does not confirmed.

In contrast, in the second method, LiNbO₃ is obtained by: obtaining a mixture powder by mixing Li₂CO₃ and Nb₂O₅ each having a diameter of less than 5 µm and firing the obtained mixture at a temperature of 950°C or more and 1000°C or less for 12 hours, and on the other hand, LaNb₃O₉ is obtained by: obtaining a mixture powder by mixing La₂O₃ and Nb₂O₅ each having a diameter of less than 5 µm and firing the obtained mixture at 1200°C for 12 hours. Here, an X-ray diffraction measurement is used for confirming the obtainment of LiNbO₃ and LaNb₃O₉. Thereafter, the obtained LiNbO₃ and LaNb₃O₉ are separately grinded then mixed, to thereby obtain a mixture powder. The mixture powder is fired at a temperature of 1190°C or more and 1250°C or less, whereby it is possible to produce the single phase LLNbO (sintered body). Whether the single phase LLNbO is produced or not can be judged by confirming whether the peak of a substance other than LLNbO is confirmed or not. In a case where it is confirmed that the sintered body is not a single phase LLNbO, from the peak of a substance other than LLNbO confirmed by an X-ray diffraction measurement, it is possible to obtain the single phase LLNbO by grinding the obtained sintered body, and repeating the grinding and firing (firing at a temperature of 1190°C or more and 1250°C or less). In a case where LiNbO₃ and LaNb₃O₉ are used as the raw material, the mixture powder before heated at a temperature of 1190°C or more and 1250°C or less in the second method (the mixture powder of grinded LiNbO₃ and LaNb₃O₉) can be used.

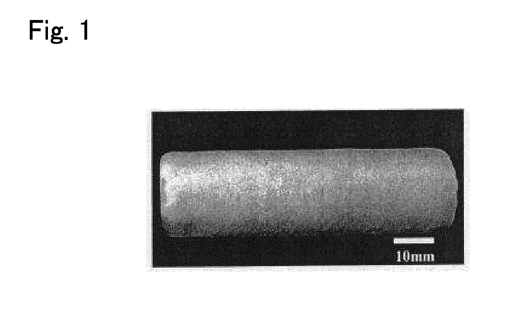

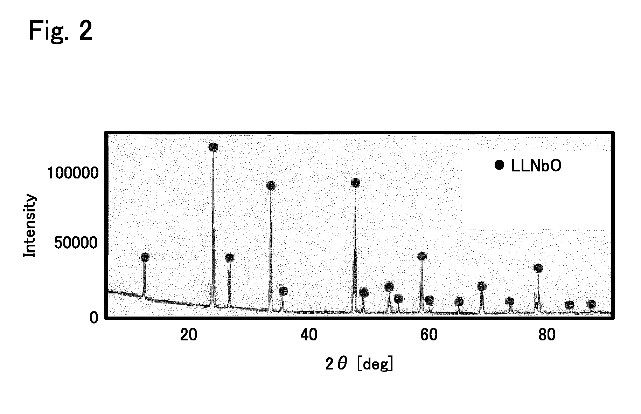

According to the first method and the second method, it is also possible to obtain an LLNbO sintered body having a density of 90% or more. The inventors of the present invention have actually confirmed that it is possible to obtain an LLNbO sintered body having a density of 82% to 96%. One example of the obtained LLNbO sintered body is shown in Fig. 1, and a result of the X-ray diffraction measurement of the obtained LLNbO sintered body (Li_{0.175}La_{0.275}NbO₃ sintered body) is shown in Fig. 2. The closed circles in Fig. 2 show peaks originated from LLNbO.

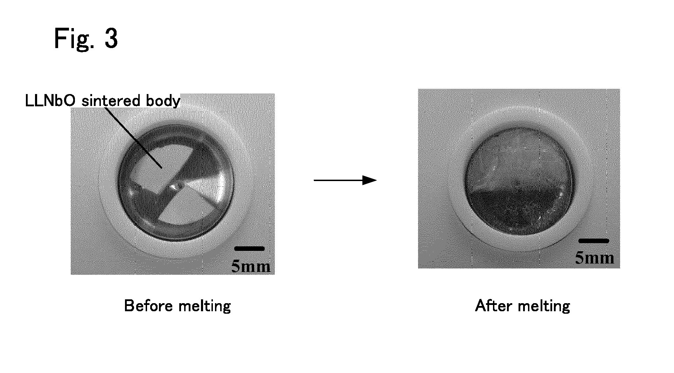

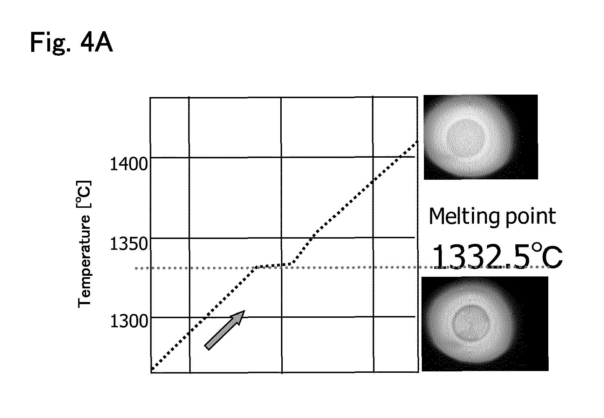

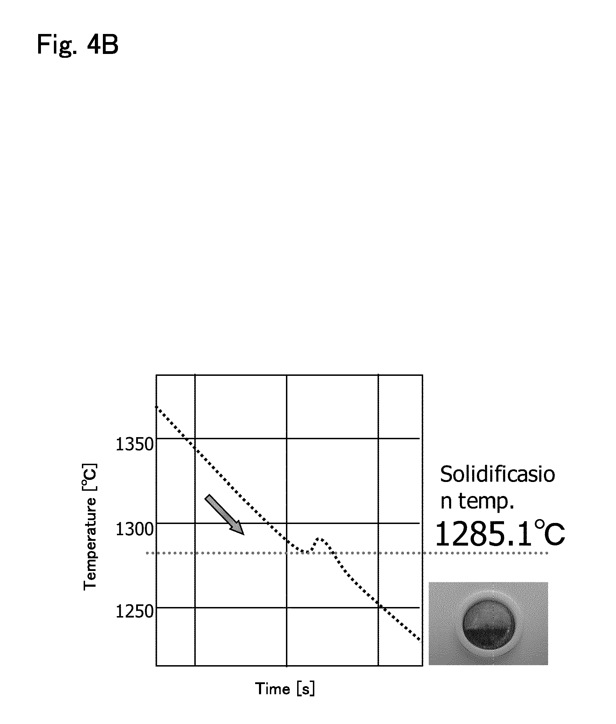

By carrying out a melting/solidifying experiment to this LLNbO after the single phase LLNbO is obtained as described above, the melting point and solidifying point of LLNbO are specified. For example, in the melting/solidifying experiment, the melting point is specified by: putting the single phase LLNbO sintered body in a platinum crucible with which a thermocouple is connected, and heating it at a predetermined temperature rising speed (for example 1 °C/min from 1000°C to 1400°C) by means of a heating furnace of resistance heating type and the like, to melt the LLNbO sintered body. Also, the solidifying point is specified by stopping the heating to decrease the temperature after the sintered body is melted, to thereby solidify LLNbO. Here, the melting point and the solidifying point can be specified by checking a state of temperature change with time measured by means of a thermal gravity/differential heat simultaneous analysis, and a state of LLNbO figured out by a direct observation. The state of the melting/solidifying experiment is shown in Fig. 3, and one example of obtained measurement results (temperature change with time) is shown in Figs. 4A and 4B. Figs. 4A and 4B show the results of Li_{0.175}La_{0.275}NbO₃, Fig. 4A shows the change with time when the temperature is increased, and Fig. 4B shows the change with time when the temperature is decreased. In Figs. 4A and 4B, a bending point from a large heat absorption and radiation is observed, and it is possible to specify the melting point of Li_{0.175}La_{0.275}NbO₃ as 1332.5°C and the solidifying point as 1285.1°C. It should be noted that in the direct observation carried out at the same time, it was also confirmed that the LLNbO sintered body was melted at 1332.5°C and solidified at 1285.1°C.

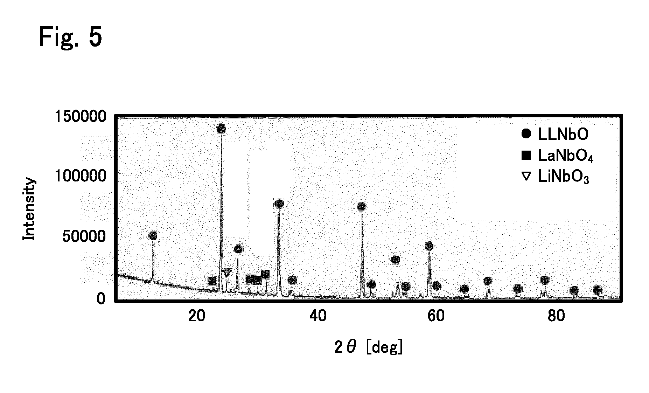

Also, a result of the X-ray diffraction measurement of the solidified Li_{0.175}La_{0.275}NbO₃ is shown in Fig. 5. From Fig. 5, the peaks of LiNbO₃ and LaNbO₄ are confirmed in addition to the peak of LLNbO. Therefore, it was found out that LiNbO₃ and LaNbO₄ are precipitated in addition to LLNbO, if LLNbo is melted thereafter solidified. The same result was obtained in both cases where the melting/solidifying experiment (specifying the melting point and solidifying point) was carried out in air atmosphere and carried out under inert gas atmosphere.

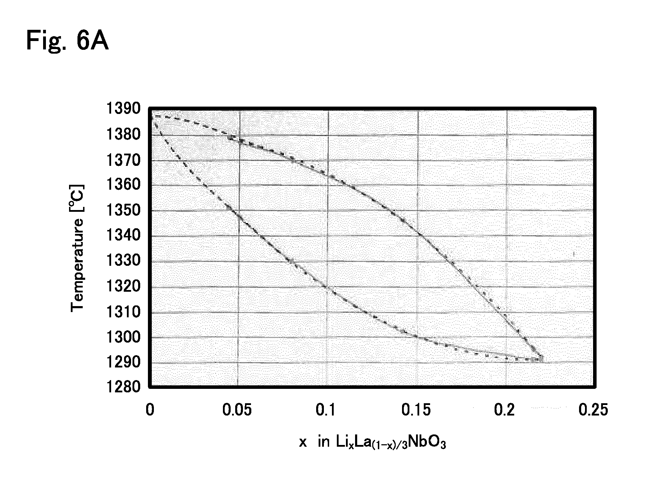

The inventors of the present invention changed the mixing ratio of Li₂CO₃, La₂O₃, and Nb₂O₅ to thereby produce single phase LiₓLa_{(i-x)/3}NbO₃ having different value x. Then, ICP (Inductively Coupled Plasma) emission spectral light spectrum analysis was carried out to the produced LiₓLa_{(1-x)/3}NbO₃ to specify the value of x, and the above-mentioned melting/solidifying examination was carried out to specify the melting point and the solidifying point. The results are shown in Fig. 6A. The solid line in Fig. 6A is a line connecting the actual measurement results, and the dashed line is a line obtained from an analogy with the solid line. In the curved lines shown in Fig. 6A, the curved line upwardly convexed corresponds to the liquidus, and the curved line downwardly convexed corresponds to the solidus.

From Fig. 6A, the melting point and the solidifying point of LLNbO within the range of 0<x≤0.23 were specified, whereby it can be estimated that the single phase LiₓLa_{(1-x)/3}NbO₃ can be produced within the range of 0<x≤0.23. Therefore, in a case where the single crystal of LiₓLa_{(1-x)/3}NbO₃ (0<x≤0.23) is produced by the producing method of the present invention, the single crystal can be produced by: heating the raw material to a temperature of the melting point which can be read from Fig. 6A or more to obtain a molten body; thereafter cooling the molten body to a temperature of the solidifying point which can be read from Fig. 6A or less. In this regard, in the cooling process, LiNbO₃ and LaNbO₄ also precipitate. However, by developing LLNbO precipitated from the liquid phase, it is possible to produce a single crystal of LLNbO. In the range of 0<x<0.23, the melting point of LLNbO is higher than the solidifying point.

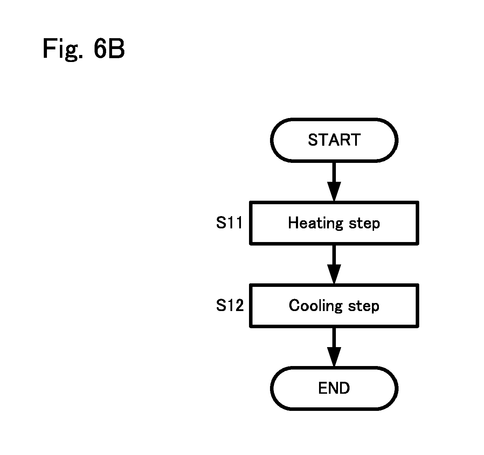

Fig. 6B shows one example of a flowchart of the producing method of the present invention. As shown in Fig. 6B, the producing method of the present invention includes a heating step S11 and a cooling step S12. The heating step S11 is a step of heating a raw material for producing a single crystal of a solid electrolyte having a perovskite structure to a temperature of a melting point of the solid electrolyte or more, to thereby obtain a molten body. For example, when a single crystal of LixLa_{(1-x)/3}NbO₃ (0<x≤0.23) is produced, the heating step S11 can be a step of heating the raw material to the melting point which can be read from Fig. 6A or more, to thereby obtain the molten body. Also, the cooling step S12 of the present invention is a step of cooling the molten body obtained in the heating step S11 to a temperature of the solidifying point of the solid electrolyte or less. For example, when the single crystal of LixLa_{(1-x)/3}NbO₃ (0<x≤0.23) is produced, the cooling step S12 can be a step of cooling the molten body to a temperature of the solidifying point which can be read from Fig. 6A or less.

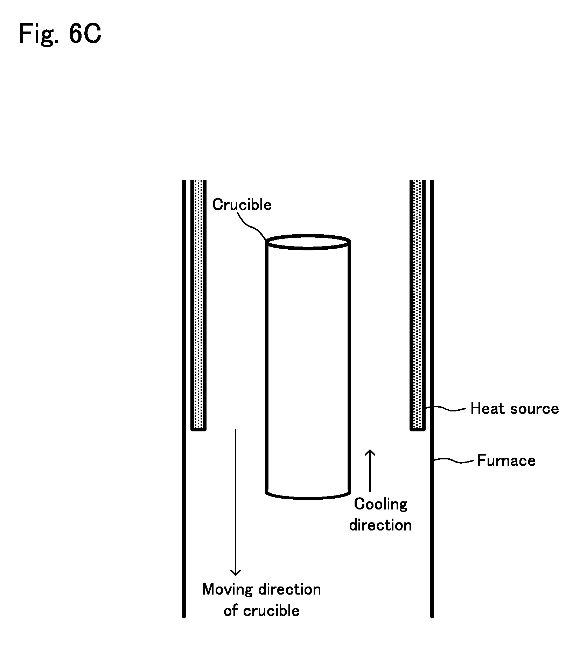

The configuration of the producing method of the present invention is not particularly limited as long as it has the heating step and the cooling step. The cooling step can be a step of cooling the molten body in one direction. Fig. 6C shows one example of cooling the molten body in one direction. As shown in Fig. 6C, when the molten body is cooled in one direction, for example, the molten body in a crucible can be cooled in one direction by: in a furnace provided with a heat source to heat a crucible which contains the molten body, moving the crucible in one direction to make a distance between the crucible and the heat source. In a case where the molten body is cooled with the configuration shown in Fig. 6C, the single crystal grows from the lower side to the upper side on the sheet of paper of Fig. 6C. Alternatively, it is also possible to cool the molten body in one direction for example by controlling the configuration of imparting the heat amount to be added to the crucible, to move a high-temperature portion of the crucible to which the heat amount is added from one end side to the other end side, and move a low-temperature portion of the crucible from one end side to the other end side, such that the low-temperature portion of the crucible follows the movement of the high-temperature portion.

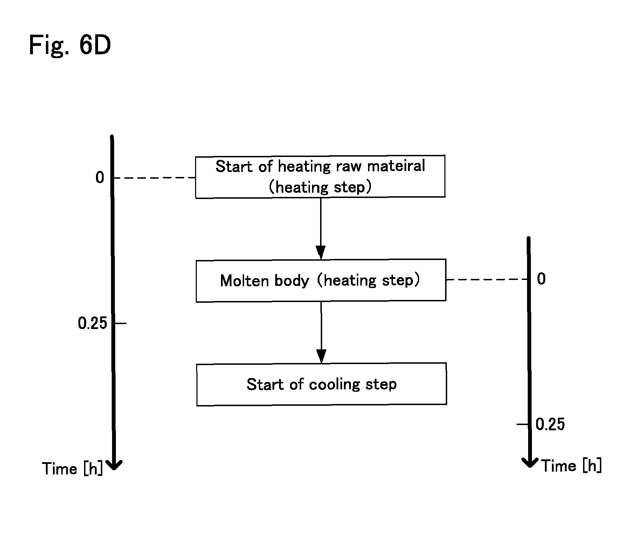

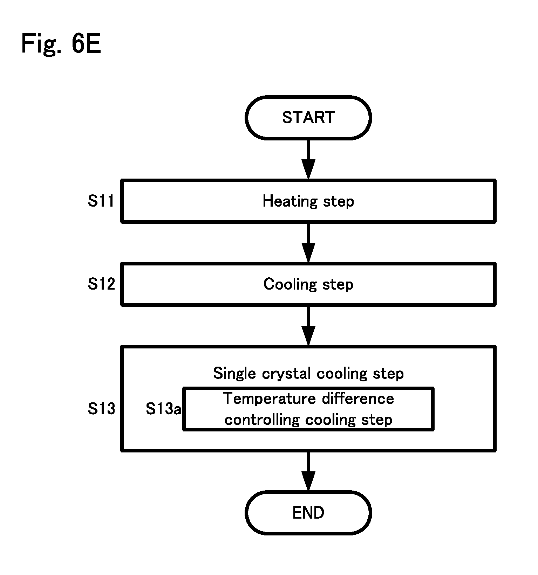

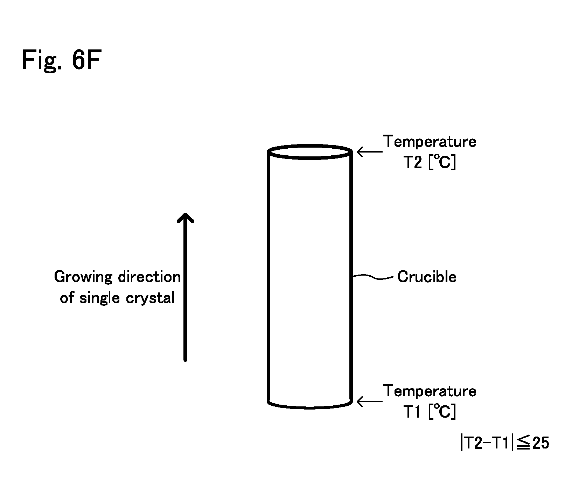

One configuration of the heating step and the cooling step of the producing method of the present invention is shown in Fig. 6D. As shown in Fig. 6D, in the producing method of the present invention, the molten body can be obtained within 0.25 hours after the heating of the raw material is started in the heating step, and the cooling step can be started within 0.25 hours after the molten body is obtained. One configuration of the producing method of the present invention is shown in Fig. 6E. In Fig. 6E, to the same step as the step shown in Fig. 6B, the same expression as that used in Fig. 6B is used, and the explanation thereof is adequately omitted. As shown in Fig. 6E, the producing method of the present invention can have a single crystal cooling step S13 after the cooling step S12. When the producing method of the present invention has the single crystal cooling step S13, the single crystal cooling step S13 preferably has a step of cooling the single crystal while making a temperature difference between the solidification starting end of the single crystal and the solidification finishing end of the single crystal as 25°C or less (temperature difference controlling cooling step S13a). Fig. 6F shows a general description of the expression "making a temperature difference between the solidification starting end of the single crystal and the solidification finishing end of the single crystal as 25°C or less". As shown in Fig. 6F, for example in a case where the growing direction of the single crystal is a direction from the lower side to the upper side on the sheet of paper of Fig. 6F, the difference between T1 and T2 is controlled so as to be 25°C or less (|T2-T1|≤25), wherein a temperature of one end (One end in the growing direction of the single crystal, the lower end of the crucible shown in Fig. 6F) of the crucible to develop the single crystal is T1 [°C], and a temperature of the other end (the other end in the growing direction of the single crystal, the upper end of the crucible shown in Fig. 6F) of the crucible to develop the single crystal is T2 [°C]. Whereby, it is possible to make the temperature difference between the solidifying starting end of the single crystal and the solidifying finishing end of the single crystal as 25°C or less.

In a case where the single crystal of LiₓLa_{(1-x)/3}NbO₃ (0<x≤0.23) is produced by the producing method of the present invention, its configuration is not particularly limited as long as the producing method has: a step of heating the raw material to a temperature of the melting point of LLNbO which can be read from Fig. 6A or more to thereby obtain a molten body; and a step of cooling the molten body to a temperature of the solidifying point of LLNbO which can be read from Fig. 6A or less. In the producing method of the present invention, a known method which can be used for producing a single crystal can be adequately employed. Examples of such a method include a vertical Bridgman method, a horizontal Bridgman method and the like.

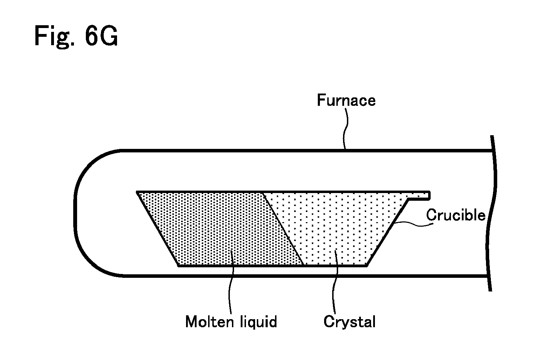

An example of a formation of the horizontal Bridgman method is shown in Fig. 6G. As shown in Fig. 6G, in the horizontal Bridgman method, the crucible in which a crystal is to be developed is arranged in a substantially horizontal manner. Then, by moving the solid/liquid interface while controlling the temperature, the crystal is developed.

It should be noted that, when the inventors tried to produce an LLNbO single crystal, the production of the LLNbO single crystal was tried by means of the vertical Bridgman method as described below, since there was no LLMnO single crystal which can be used as a seed crystal. However, according to the present invention, it became possible to produce an LLNbO single crystal. Therefore, hereafter it is possible to produce an LLNbO single crystal by using the LLNbO single crystal produced by the present invention as a seed crystal. As a method which can be used in producing an LLNbO single crystal, a known method such as CZ (Czochralski) method and FZ (Floating Zone) method can be exemplified.

In the present invention, the crucible used in producing the single crystal is not limited as long as it is configured by a substance having alkali corrosion resistant property under the environment of the heating step, which does not react with the molten body. Examples of such a substance include platinum and the like. Therefore, in the present invention, a platinum crucible, a crucible whose surface is covered by platinum and the like can be used.

### Examples

### 1. Production of LixLa_{(1-x)/3}NbO₃ single crystal

Li₂CO₃ (manufactured by SANTOKU CORPORATION, purity of 99.9%), La₂O₃ (manufactured by NIPPON COKE & ENGINEERING CO., LTD., purity of 99.9%), and Nb₂O₃ (manufactured by NIPPON COKE & ENGINEERING CO., LTD., purity of 99.9%), each having a diameter of less than 5 µm were used. Their mixing ratio was changed, whereby single phase LixLa_{(1-x)/3}NbO₃ sintered bodies in which the value of x was changed by means of the above first method were obtained. For the X-ray diffraction to confirm whether the obtained sintered bodies were single phase LiₓLa_{(1-x)/3}NbO₃ or not, a horizontal X-ray diffraction apparatus (manufactured by Rigaku Corporation, Smart Lab. The same is applied hereinafter) was used. Also, for the ICP emission spectral analysis method to specify the value of x, an ICP emission spectral analysis apparatus (manufactured by Shimadzu Corporation, ICPS-8000) was used.

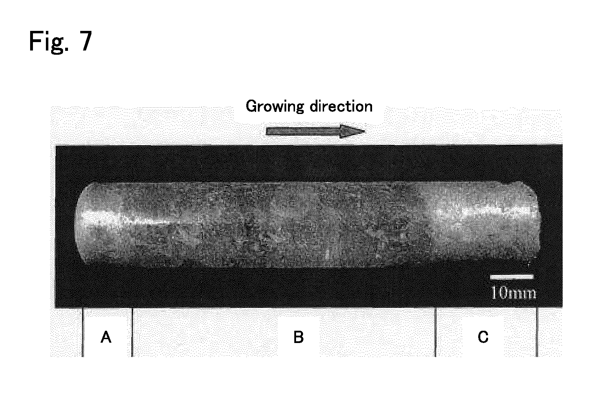

Next, in a platinum crucible having a size with which the size of the single phase LLNbO sintered body was approximately 90% or more and 97% or less of the inner diameter of the crucible (inner diameter: 20 mm to 50 mm, height: 100 mm to 180 mm), the produced single phase LLNbO sintered body was filled, and installed to a vertical Bridgman furnace. It was possible to arrange a thermocouple to an arbitrary position on a bottom surface or on a side surface of the platinum crucible, and the temperature control in developing single crystal was carried out by controlling the temperature specified by means of a B-type or R-type thermocouple. Thereafter, the LLNbO sintered body was heated to a temperature of the melting point which can be read from Fig. 6A or more to be melted, whereby a molten body was obtained. After that, the platinum crucible was moved downwardly in order to decrease the temperature of the molten body to the solidifying point which can be read from Fig. 6A or less, whereby the molten body was solidified in one direction. For example, when x=0.1, the melting point can be read as 1364°C, and the solidifying point can be read as 1320°C, from Fig.6A. Therefore, when x=0.1, the sintered body was heated to 1390°C which is higher than 1364°C, and the platinum crucible was held with this temperature state, whereby the molten body was obtained. After that, in a vertical Bridgman furnace whose temperature was controlled such that its temperature gradient after the point (the region positioned lower than the point) where was set to be the solidifying point (1320°C) was 0.4 °C/mm, Li_{0.1}La_{0.3}NbO₃ single crystal was tried to be produced by moving the platinum crucible downwardly at a speed of 0.45 mm/h. A solidified body (diameter 20 mm x length 92 mm) taken out from the platinum crucible is shown in Fig. 7. The direction from the left side to the right side on the sheet of paper of Fig. 7 is the growing direction of the single crystal. As shown in Fig. 7, the platinum crucible used this time did not have any tapered portion or selector portion which selects a crystal to develop.

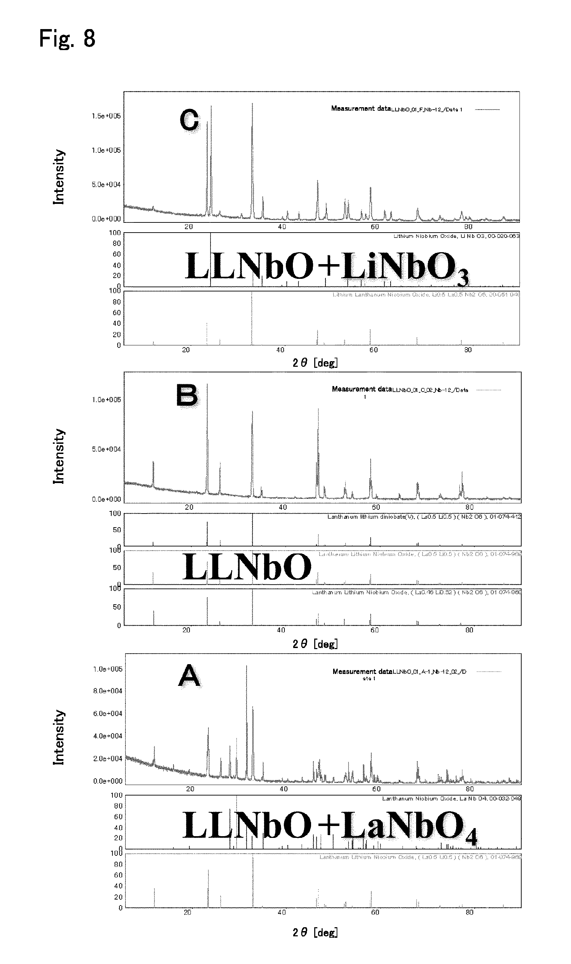

Also, the solidified body was cut at each region shown by A, B, C in Fig. 7 and a sample cut off from each cut surface was analyzed by means of a horizontal X-ray diffraction apparatus, whereby each region of A, B, C was examined. The results are shown in Fig. 8. A, B, C in Fig. 8 correspond to A, B, C in Fig. 7.

As shown in Fig. 8, the peaks originated from LLNbO and LaNbO₄ were confirmed from A region, the peak originated from LLNbO was confirmed from B region (having a length of approximately 65 mm), and the peaks originated from LLNbO and LiNbO₃ were confirmed from C region. From the results, it was confirmed that B region was a region of single phase of LLNbO.

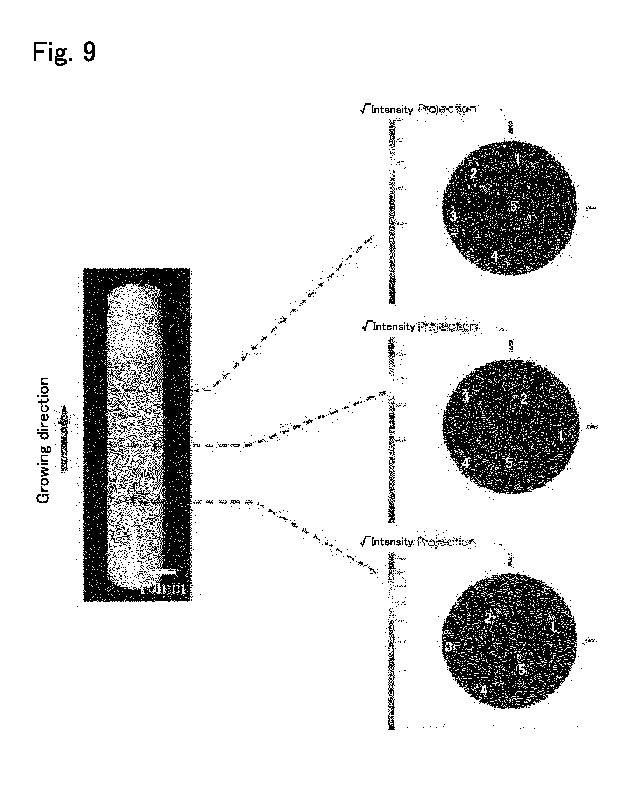

Next, in order to confirm that B region includes the single crystal, 3 points in B region was cut in a wafer manner, such that the normal direction of the cut surface is parallel to the growing direction of the single crystal. Then, a measurement of poles of the cut surface was carried out by means of the horizontal X-ray diffraction apparatus. The results are shown in Fig. 9. The direction from the lower side to the upper side on the sheet of paper of Fig. 9 is the growing direction of the single crystal.

As shown in Fig. 9, with a measurement angle of α=31.28°, a (110) pole figure was obtained at every portion. From the results, it was confirmed that B region includes the single crystal. The difference in β angle at the 3 pole figures shown in Fig. 9 (the reason why they were seen as rotated) is originated from the difference in the angle of sample arrangement when the measurement was carried out.

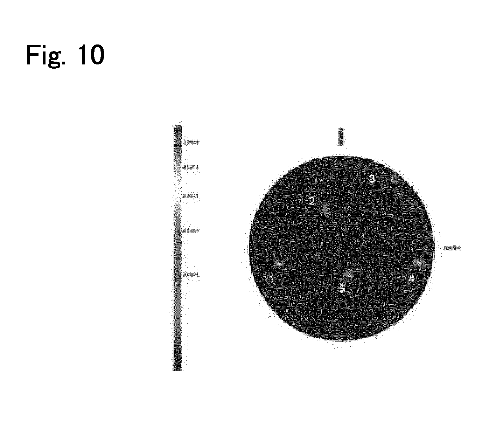

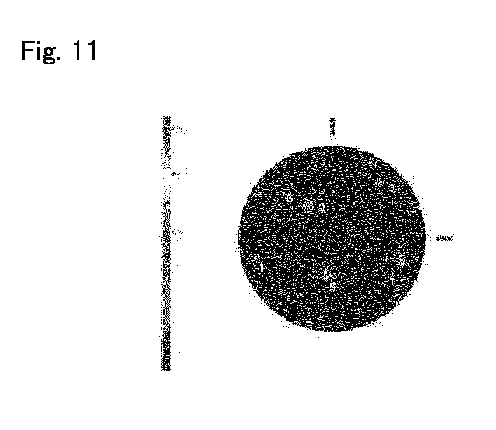

Similarly, Figs. 10 and 11 show results of a pole measurement to the grown sample in which x was confirmed as 0.075, and the grown sample in which x was confirmed as 0.22, by means of ICP emission spectral analysis. Fig. 10 is the pole figure of a crystal surface in the crystal in which x=0.075, and Fig. 11 is the pole figure of a crystal surface in the crystal in which x=0.22.

As shown in Fig. 10, when x=0.075, a single pattern of the (110) pole figure was obtained at the measurement angle of α=32.05. Also, as shown in Fig. 11, when X=0.22, a single pattern of the (110) pole figure was obtained at the measurement angle of α=32.45. From these results, it was confirmed that the single crystal was produced in both cases of x=0.075 and x=0.22. The reason why the pole figures of Fig. 10 and 11 are different from the pole figure of Fig. 9 is that the measurement surfaces from which the results of Figs. 10 and 11 were obtained corresponds to the opposite surface of the measurement surface from which the result of Fig. 9 was obtained.

From the above, it was confirmed that an LixLa_{(1-x)/3}NbO₃ single crystal can be produced by the producing method of the present invention. It should be noted that, as a result of examining the optimum conditions by changing the growing speed (moving speed of the platinum crucible) of the singe crystal, it was confirmed that, in a case where a crucible not having taper portions or selector portions is used, it is possible to promote crystal development by competition growth to obtain the single crystal by having a growing speed of 0.8 mm/h or less, and it is possible to increase the proportion of the single crystal to B region by having a growing speed of 0.5 mm/h or less.

### 2. Ion conductivity evaluation

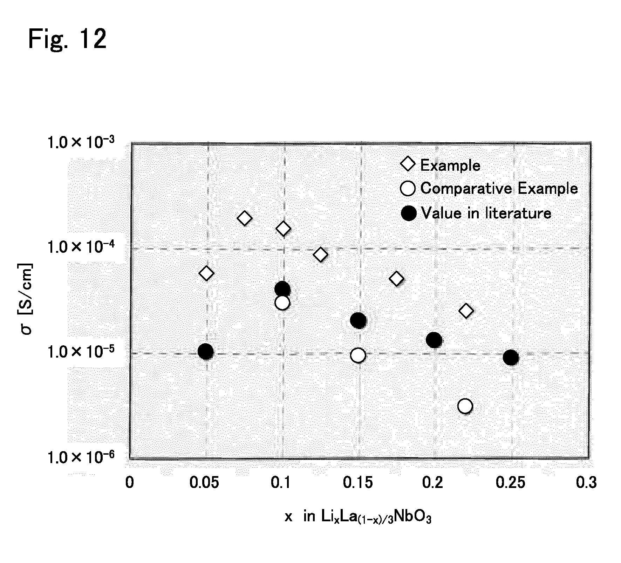

From the LLNbO single crystal produced by the above method, a crystal having a size of 10 mm x 10 mm x thickness of 0.5 mm or more and 1 mm or less was cut off. Then, the crystal cut off was sandwiched by a pair of electrodes such that a direction going from one electrode to the other electrode was parallel to the growing direction of the crystal. A bulk impedance of the crystal was specified by means of an AC impedance method with an AC impedance measurement apparatus (manufactured by Solartron, 1470E+FRA. The same is applied hereinafter), and the ion conductivity was calculated by means of the specified bulk impedance. The relationship between the value of x specified by ICP emission spectral analysis and the ion conductivity (Example) is shown in Fig. 12. The ion conductivity σ [S/cm] is taken along the vertical axis and the value of x in LiₓLa_{(1-x)/3}NbO₃ is taken along the horizontal axis in Fig. 12.

Also, regarding the single phase LLNbO used as the raw material in producing the LLNbO single crystal (LLNbo produced by a process of firing it at a temperature of 1190°C or more and 1250°C or less, before going through the heating step and the cooling step of the producing method of the present invention), the ion conductivity (Comparative Example) was calculated in the same manner by means of the AC impedance measurement apparatus. The result is shown in Fig. 12 together with the ion conductivity of LiₓLa_{(1-x)/3}NbO₃ described in a literature (value in literature).

In Fig. 12, the LLNbO single crystal produced by the producing method of the present invention showed a higher conductivity than that of Comparative example and the value in literature in all compositions to which the examination was carried out. Therefore, it can be considered that it is possible to improve the performance of a solid-state battery, by using the LLNbO single crystal of the present invention to the solid-state battery. Also, it had been considered that LLNbO shows the maximum ion conductivity when x=0.1; however, from Fig. 12, it was found that LLNbO shows the maximum ion conductivity when x is around 0.075.

### 3. Examination of single crystal

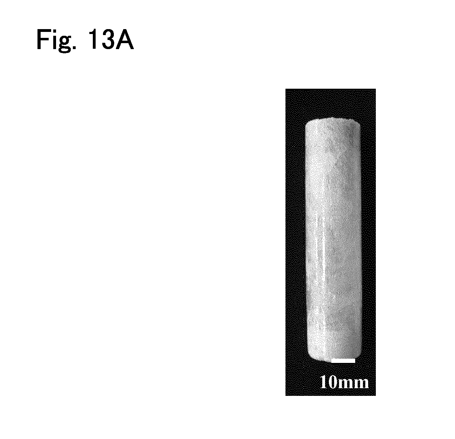

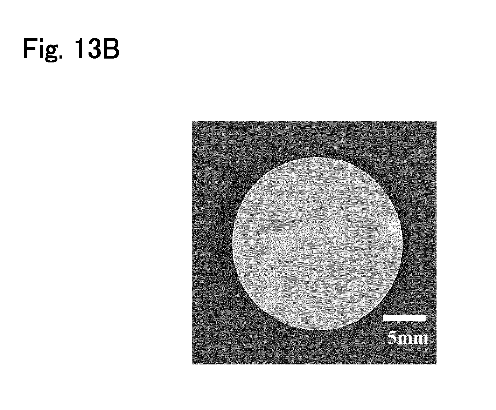

The appearance of the LLNbO single crystal (hereinafter sometimes simply referred to as "single crystal") produced by the above method was observed and the state of the inside of the single crystal was examined by cutting the single crystal perpendicular to the growing direction of the single crystal. The appearance of the single crystal is shown in Fig. 13A, and the cross section of the single crystal is shown in Fig. 13B.

As shown in Fig. 13A, the single crystal was transparent as a whole. However, large cracks were found in a few points. This cracks included cracks generated in a manner to be transmitted from the different phase formed at an end portion (corresponds to A region in Fig. 7. The same is applied hereinafter) on the solidification starting side of the single crystal.

As shown in Fig. 13B, cracks were confirmed inside the single crystal. Also, some inclusions appeared to be white were randomly existed inside the single crystal. Here, the cracks in the surface of the single crystal did not exist before the single crystal was cut, and generated when the single crystal was cut (since the single crystal was transparent, the portion where was confirmed as not having cracks before cutting was cut). Also, by confirming the cross-sectional surface of the single crystal, it was found that most of the cracks in the surface of the single crystal were started from the white inclusions. From the above results, it was found that the inclusions existing inside the single crystal contributes to generation of cracks.

Next, regarding the single crystal whose appearance and the cross-sectional surface were observed, the inclusions were tried to be identified (identification of the inclusions) by means of an X-ray diffraction. Specific substance could not be identified since the inclusions were small in amount. It is presumed that the inclusions were a small amount of different phase.

### 4. Study of reducing method of different phase

As shown in Fig. 13A, the different phase was formed to the solidification starting end side and the solidification finishing end side of the single crystal produced by the producing method of the present invention, and cracks were transmitted, starting from the different phase existing in the end portion of the solidification starting side. Therefore, in order to reduce the cracks, it is considered that decreasing the region of different phase formed to the end portion of the solidification starting side of the single crystal is effective, and by reducing the different phase in the end portion, it becomes possible to increase the percentage of the single crystal region which does not have cracks. Therefore, a study was carried out regarding the reducing method of the region of the different phase.

Normally, in the Bridgman method, before solidification (crystal growth) is started, the sample is melted and held while heated, thereafter held for a long time until the whole heat distribution and convective flow of the constituent of molten liquid become stably settled. However, if the single crystal is produced with this method, a lot of different phases are formed to the solidification starting end side and the solidification finishing end side of the single crystal. Therefore, the single crystal needs to be produced by means of a different method from the normal method, in order to reduce the region of the different phase. As a result of an intensive study, the inventors have found out that the region of the different phase can be reduced by, after melting the raw material in a short time, starting cooling the bottom portion of the crucible within a predetermined time to develop the single crystal. More specifically, for example, it was possible to reduce the region of the different phase by: increasing the temperature in the heating furnace at the maximum temperature increasing speed with which the surrounding member including the crucible containing the raw material can endure the thermal shock; starting cooling of the bottom portion of the crucible immediately after confirming the temperature by means of a thermocouple installed in the crucible and confirming that the raw material is completely melted, by means of a CCD camera installed to upper part of the furnace body.

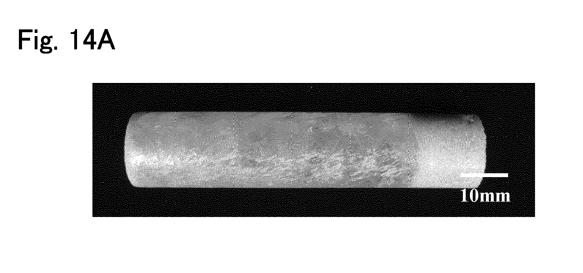

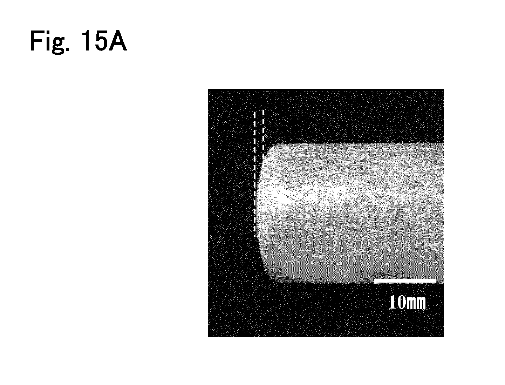

The crucible containing the raw material and installed in the heating furnace was heated at a temperature increasing speed of 80 °C/min average to melt the raw material (the time required for melting: 0.25 hours), and the cooling of the bottom portion of the crucible was started within 0.25 hours after the raw material was melted, to thereby develop the single crystal at a growing speed of 0.7 mm/h. The single crystal produced as above (hereinafter may be referred to as "sample of Condition 1") is shown in Fig. 14A, and an enlarged view of a solidification starting end side of the single crystal shown in Fig. 14A is shown in Fig. 15A.

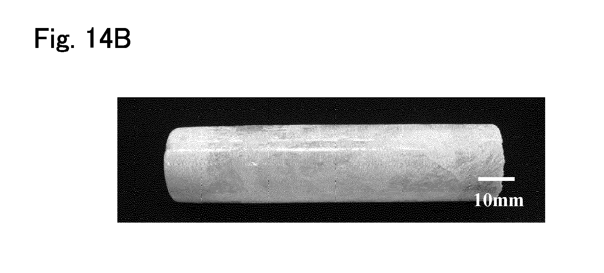

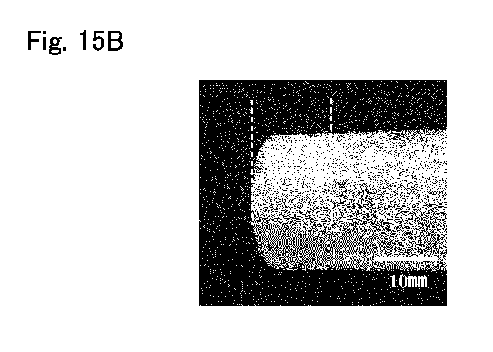

Also, the crucible containing the raw material and installed in the heating furnace was heated at a temperature increasing speed of 3.75 °C/min average to melt the raw material (the time required for melting: 6 hours), and the cooling of the bottom portion of the crucible was started within 12 hours after the raw material was melted, to thereby develop the single crystal at a growing speed of 0.7 mm/h. The single crystal produced as above (hereinafter the crystal may be referred to as "sample of Condition 2") is shown in Fig. 14B, and an enlarged view of a solidification starting end side of the single crystal shown in Fig. 14B is shown in Fig. 15B.

For the purpose of easy confirmation of the region of the different phase, the end portion on the solidification starting end side of the single crystal and the boundary portion of the region of the different phase and the single crystal region were shown by dashed lines in Figs. 15A and 15B. That is, the region sandwiched by two dashed lines corresponds to the region of the different phase.

As shown in Fig. 15A, regarding the sample of Condition 1, the thickness of the region of the different phase formed on the solidification starting end side of the single crystal was around 1 mm. In contrast, as shown in Fig. 15B, regarding the sample of Condition 2, the thickness of the region of the different phase formed on the solidification starting end side of the single crystal was around 12 mm to 13 mm. As shown from the above results, it was possible to reduce the region of the different phase by melting the raw material by rapidly increasing the temperature, thereafter starting cooling sooner than before (for example within 0.25 hours or less). Also, the sample of Condition 1 in which the region of the different phase was reduced had fewer cracks than that of the sample of Condition 2. It can be conjectured that this is because the cracks observed in the single crystal were generated due to the difference in thermal expansion between the different phase and the single crystal.

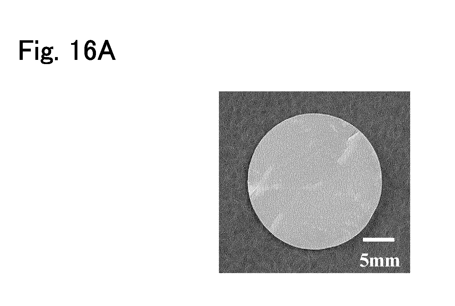

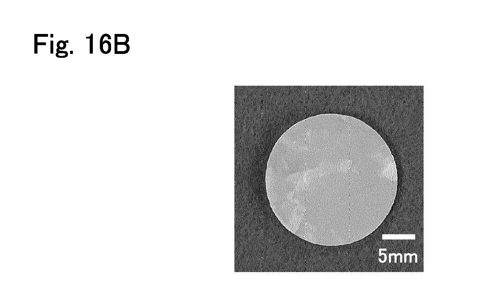

The cross-sectional surface of the single crystal (the portion corresponding to B region in Fig. 7. Hereinafter the portion may be referred to as "single crystal region") cut perpendicular to the growing direction of the sample of Condition 1 is shown in Fig. 16A, and the cross-sectional surface of the single crystal region cut perpendicular to the growing direction of the sample of Condition 2 is shown in Fig. 16B. The inside of the single crystal region of Condition 1 shown in Fig. 16A had fewer different phases (inclusions) precipitated and appeared as white than that precipitated inside the single crystal region of Condition 2 shown in Fig. 16B. It can be considered that this is because the constituent of the remained molten liquid became closer to a constituent which was not suitable for precipitation of the different phase, as a result of reduction of the region of the different phase on the solidification starting end side of the single crystal.

As described above, by starting the cooling in short period after the raw material is melted by rapidly increasing the temperature, it becomes possible to reduce the thickness of the region of the different phase formed on the solidification starting end side of the single crystal. Then, regarding the cases where x in LiₓLa_{(1-x)/3}NbO₃ was 0.1, 0.15, and 0.2, the single crystal was produced by means of the method with which the sample of Condition 1 was produced and the method with which the sample of Condition 2 was produced, and the length of the obtained single crystal region was examined. The results are shown in Table 1. In Table 1, "Condition 1" means that the single crystal was produced in the same conditions as that of the sample of Condition 1, and "Condition 2" means that the single crystal was produced in the same conditions as that of the sample of Condition 2. In each case, the weight of the raw material was 140 g, the growing speed of the single crystal was 0.7 mm/h, and the single crystal having a diameter of 20 mm was produced.

**[Table 1]**

| | Length of LiₓLa_{(1-x)/3}NbO₃ single crystal [mm] | | |
|---|---|---|---|
| | X=0.1 | X=0.15 | X=0.2 |
| Condition 1 | 71.0 | 68.1 | 62.9 |
| Condition 2 | 52.2 | 45.3 | 40.7 |

From Table 1, it was confirmed that it was possible to make the length of the single crystal region longer, by producing the single crystal by means of the method of Condition 1, than that produced by means of the method of Condition 2. That is, by producing the single crystal by means of the method of Condition 1, it was possible to increase the yield late (the rate of the single crystal region to the whole sample) of the single crystal.

In a case where the cooling is started immediately after the raw material is rapidly melted, in order to reduce the region of the different phase, the temperature in the heating furnace may be unstable since the temperature change in the heating furnace from the end of melting to the starting of cooling is large. Therefore, in view of easily stabilizing the temperature in the heating furnace, it is preferable to use a heating furnace provided with a larger amount of heat insulation material than before, or to directly control the temperature in the heating furnace. In producing the single crystal of the Condition 1, the temperature change in the heating furnace after the raw material was melted and before the cooling was started was 0.42°C or more and 0.75°C or less.

Also, in view of making the raw material rapidly melt, it is preferable that the heating furnace is provided with a hot zone having a small temperature gradient (for example approximately 0.05 °C/mm or less) and having a predetermined value or more of length (for example, approximately 150 mm or more).

### 5. Study of method for making different phase unevenly exist

In both samples of Condition 1 and Condition 2, the inclusions (different phase) in the single crystal region were randomly precipitated, and any regularity was not specifically confirmed. As described, in the raw material in which the different phase is precipitated at the same time, it is difficult to predict the configuration of precipitation of the different phase other than the main constituent, which precipitates in a small amount.

As described above, when the single crystal region is cut, cracks are formed starting from the inclusions. Therefore, in a case where the single crystal is produced by the method studied above, the point where the inclusions do not exist needs to be selectively cut out to obtain the single crystal which does not have cracks. With the producing method of the single crystal having this process, the producing efficiency of the single crystal is degraded. Therefore, it is preferable to specify a method of increasing (making the inclusions (different phase) exist concentrating to a specific region) the abundance ratio of the single crystal region which does not include the inclusions (different phase).

As a result of an intensive study, the inventors have found out that it is possible to make the inclusions (different phase) unevenly exist by continuously (for example continuously in one direction) developing the single crystal while making the solid/liquid interface in developing the single crystal inclined to the surface having the growing direction of the single crystal as a normal direction.

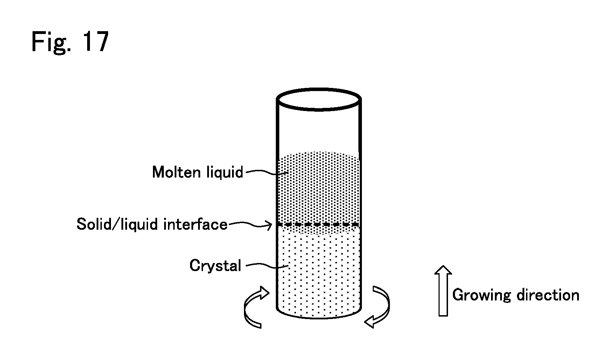

In a case where the single crystal is developed by means of a vertical Bridgman method, conventionally, the single crystal was developed while a crucible holding the molten liquid is rotated at a certain speed, with a state in which the unevenness of the temperature in the furnace was difficult to affect the crucible holding the molten liquid. Specifically, the temperature distribution at a plane surface having the growing direction of the single crystal as a normal direction was even, and the single crystal was continuously developed in one direction by having a moderate temperature gradient from the crystallization temperature (solidifying temperature) to the temperature of the molten liquid, with the crucible slowly moving. The state of the crystal in the crucible, the solid/liquid interface, and the molten liquid in a conventional vertical Bridgman method are shown in Fig. 17 being simplified. As shown in Fig. 17, in the conventional Bridgman method, the growing direction of the crystal was substantially perpendicular to the solid/liquid interface.

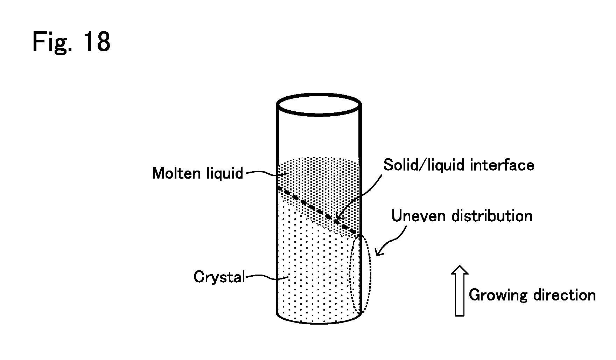

In Fig. 18, the state of the crystal in the crucible, the solid/liquid interface, and the molten liquid when the single crystal is developed in one direction while the solid/liquid interface in developing the single crystal is inclined is shown being simplified. In the state shown in Fig. 18, the solid/liquid interface is not horizontal but inclined. This configuration makes it possible to unevenly precipitate the inclusions (different phase) in the region (the side where the molten liquid exists when the sample is cut at the horizontal surface including the single crystal and the molten liquid) surrounded by the dashed line in Fig. 18.

It is possible to realize the solid/liquid interface inclined to the surface which has the growing direction of the single crystal as a normal direction as shown in Fig. 18, by employing one of the following methods, or employing two or more of the following methods in combination:
(a) arranging a crucible containing the raw material, to a point where is not the center in an axial direction in a heating furnace having a symmetric temperature distribution from the center in the axial direction to outside;
(b) arranging a crucible containing the raw material, in a heating furnace having a symmetric temperature distribution from the center in the axial direction to outside, such that the axial direction of the crucible inclines to a vertical direction;
(c) providing a difference between the heating capacity to heat one side of a crucible containing the raw material and the heating capacity to heat the other side of the crucible;
(d) arranging a heat insulation material on one side of a crucible (between the crucible and a heater) containing the raw material;
(e) making the shape of the cross section of a heating furnace as an ellipse wherein an axial direction of the heating furnace is a normal direction;
(f) providing a difference between the thickness on one side of a crucible to contain the raw material and the thickness on the other side (making the thickness of the crucible uneven);
(g) making the constituent material on one side of a crucible to contain the raw material and the constituent material on the other side not identical.

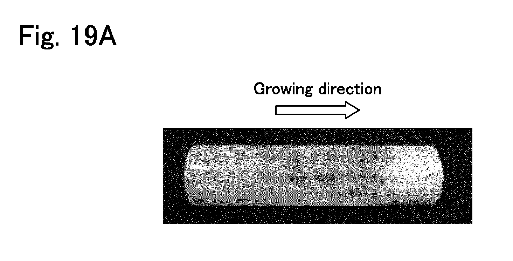

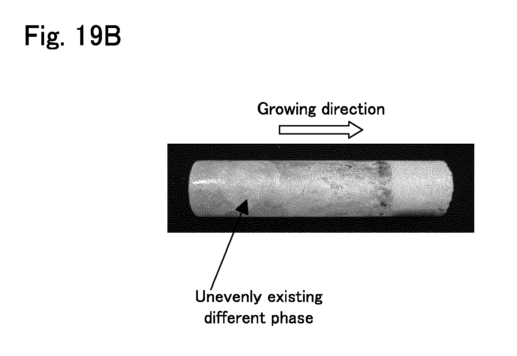

Figs. 19A and 19B show the LLNbO single crystal continuously developed by controlling the difference between the maximum temperature point and the minimum temperature point in the horizontal surface to be 5°C or more and 7°C or less and realizing the state shown in Fig. 18, by combining the above (a) and (d). Fig. 19B corresponds to the opposite side of the view of Fig. 19A. The color was different between Fig. 19A and Fig. 19B. More specifically, since the different phase did not unevenly exist on the side shown in Fig. 19A, the surface was transparent especially at the single crystal region. However, since the different phase unevenly existed on the side shown in Fig. 19B, the surface was white in whole region including the single crystal region.

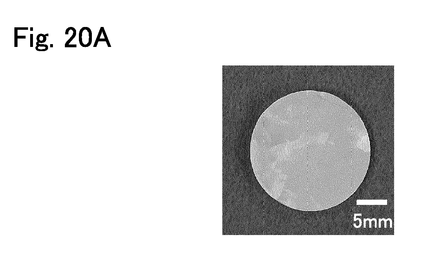

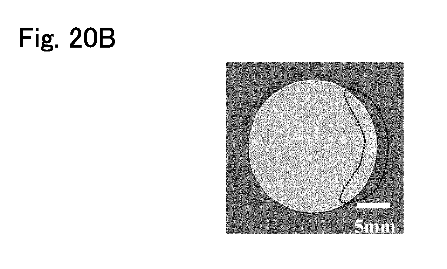

The cross section of the LLNbO single crystal continuously developed with the state shown in Fig. 17 is shown in Fig. 20A, and the cross section of the single crystal region of the sample shown in Figs. 19A and 19B is shown in Fig. 20B. Any inclusion did not unevenly exist in Fig. 20A, whereas in Fig. 20B, the region surrounded by the dashed line appeared in white, and the inclusions unevenly existed in the white region.

In the LLNbO single crystal, it was possible to unevenly precipitate the different phase on a lower side in a vertical direction of the inclined solid/liquid interface, and by making the different phase unevenly precipitated (unevenly exist), it was also possible to make the ratio of the single crystal region not having inclusions (different phase) in the surface to the cross section as 90% or more. By making the different phase unevenly exist with the above method, the generation of cracks that used to easily occur in the surface of the single crystal in processing was prevented, and it became possible to easily cut the single crystal region not having the different phase.

By making the different phase unevenly exist with the above method, it became possible to analyze the constituent of the different phase. Therefore, the constituent of the different phase was tried to be specified by an X-ray diffraction measurement. As a result, it was found out that the constituent of the different phase was LiNb₃O₈.

The method for reducing the different phase in the LLNbO single crystal and the method for making the different phase unevenly exist were explained above. However, these methods can be applied not only to the LLNbO single crystal but also in producing another single crystal accompanied by precipitation of different phase.

### 6. Study of method for preventing inner defect in single crystal

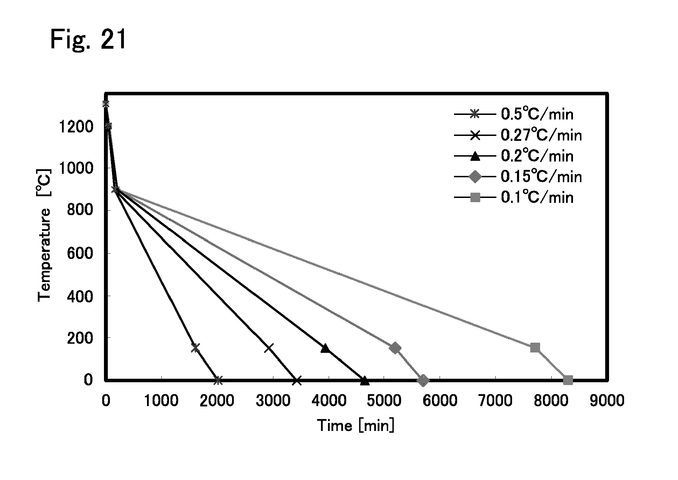

The inventors further carried out a study regarding a method of easily preventing the inner defect (e.g. cracks) in the single crystal, capable of carrying out with the above-mentioned methods of reducing the different phase and making the different phase unevenly exist, or capable of carrying out separately from these methods. More specifically, the study was carried out regarding a method of cooling the single crystal produced by going through the step of melting the raw material by heating it to a temperature of the melting point or more thereafter cooling it to a temperature of the solidifying point or less, to eventually have a normal temperature. Occurrence status of the inner defect in the LLNbO single crystal was examined by changing conditions regarding the temperature difference (25°C, 31°C, 52°C) between the solidification starting end and the solidification finishing end of the LLNbO single crystal, and the cooling speed (0.5°C/min, 0.27°C/min, 0.2°C/min, 0.15°C/min, 0.1°C/min) in cooling the single crystal from 900°C to 150°C. The results are shown in Table 2. The temperature profile in cooling the single crystal is shown in Fig. 21.

**[Table 2]**

| | | Cooling speed [°C/min] | | | | |
|---|---|---|---|---|---|---|
| | | 0.5 | 0.27 | 0.2 | 0.15 | 0.1 |
| Temperature difference | 25°C | occurred in whole | partly occurred | none | none | none |
| | 31°C | occurred in whole | occurred in whole | partly occurred | partly occurred | partly occurred |
| | 52°C | occurred in whole | occurred in whole | occurred in whole | occurred in whole | occurred in whole |

From Table 2, the following results were obtained:
(i) by cooling the single crystal while controlling the difference between the temperature of one end of the single crystal region (solidification starting end of the single crystal) and the temperature of the other end (solidification finishing end of the single crystal) to be 25°C or less, the inner defect in the single crystal was easy to be reduced;
(ii) by making the cooling speed in cooling the single crystal from 900°C to 150°C as less than 0.27°C/min, the inner defect in the single crystal was easy to be reduced.

## Claims

1. A solid electrolyte single crystal having a perovskite structure.

2. The solid electrolyte single crystal having a perovskite structure according to claim 1, whose composition formula is LiₓLa_{(1-x)/3}NbO₃.

3. The solid electrolyte single crystal having a perovskite structure according to claim 2, wherein 0<x≤0.23.

4. A method for producing a solid electrolyte single crystal having a perovskite structure, the method comprising:
a heating step of heating a raw material for producing a single crystal of a solid electrolyte having a perovskite structure to a temperature of a melting point of the solid electrolyte or more to obtain a molten body; and
a cooling step of cooling the molten body to a temperature of a solidifying point of the solid electrolyte or less.

5. The method for producing a solid electrolyte single crystal having a perovskite structure according to claim 4, wherein the cooling step is a step of cooling the molten body in one direction.

6. The method for producing a solid electrolyte single crystal having a perovskite structure according to claim 4 or 5, wherein the single crystal is grown by means of a Bridgman method.

7. The method for producing a solid electrolyte single crystal having a perovskite structure according to any one of claims 4 to 6, wherein a composition formula of the solid electrolyte is LiₓLa_{(1-x)/3}NbO₃.

8. The method for producing a solid electrolyte single crystal having a perovskite structure according to claim 7, wherein 0<x≤0.23.

9. The method for producing a solid electrolyte single crystal having a perovskite structure according to claim 8, wherein the melting point is 1291°C or more and less than 1386°C.

10. The method for producing a solid electrolyte single crystal having a perovskite structure according to claim 8 or 9, wherein the solidifying point is 1291°C or more and less than 1386°C.

11. The method for producing a solid electrolyte single crystal having a perovskite structure according to any one of claims 4 to 10, wherein in the heating step, the molten body is obtained within 0.25 hours after heating of the raw material is started, and the cooling step is started within 0.25 hours after the molten body is obtained.

12. The method for producing a solid electrolyte single crystal having a perovskite structure according to any one of claims 4 to 11, wherein the molten body is cooled to a temperature of the solidifying point of the solid electrolyte or less in the cooling step, while a solid/liquid interface formed in the cooling step is inclined to a surface having a growing direction of the single crystal as a normal direction.

13. The method for producing a solid electrolyte single crystal having a perovskite structure according to any one of claims 4 to 12, the method comprising:
after the cooling step, a single crystal cooling step of cooling the obtained single crystal,
wherein the single crystal cooling step comprises a step of cooling the single crystal while making a temperature difference between a solidification starting end of the single crystal and a solidification finishing end of the single crystal as 25°C or less.

14. The method for producing a solid electrolyte single crystal having a perovskite structure according to claim 13, wherein in the step of cooling the single crystal while making the temperature difference between the solidification starting end of the single crystal and the solidification finishing end of the single crystal as 25°C or less, a cooling speed of the single crystal in a process in which the temperature of the single crystal reaches from 900°C to 150°C is made to be less than 0.27°C/min.
